**Europäisches Patentamt**

**European Patent Office**

**Office européen des brevets**

(19)

(11) Numéro de publication: **0 154 633**
**B1**

# FASCICULE DE BREVET EUROPÉEN

(12)

(45) Date de publication du fascicule du brevet:
20.07.88

(51) Int. Cl.⁴: **B 23 P 19/00**

(21) Numéro de dépôt: **84903047.3**

(22) Date de dépôt: **22.08.84**

(86) Numéro de dépôt international:
**PCT/CH 84/00131**

(87) Numéro de publication internationale:
**WO 85/01002 (14.03.85 Gazette 85/07)**

(54) **ROBOT D'ASSEMBLAGE COMPRENANT UN DISPOSITIF DE TRANSPORT COLLECTIF DES PIECES A ASSEMBLER, PROCEDE D'ASSEMBLAGE ET SON APPLICATION.**

(30) Priorité: **26.08.83 CH 4691/83**

(43) Date de publication de la demande:
**18.09.85 Bulletin 85/38**

(45) Mention de la délivrance du brevet:
**20.07.88 Bulletin 88/29**

(84) Etats contractants désignés:
**AT BE CH DE FR GB IT LI LU NL SE**

(56) Documents cité:
**WO-A-84/02249**
**BE-A-666 913**
**DE-A-2 915 366**
**FR-A-2 508 362**
**US-A-1 518 917**
**US-A-4 173 824**

(73) Titulaire: **C O D Inter Techniques SA, 16, rue Albert Gos, CH- 1206 Genève (CH)**

(72) Inventeur: **HORVATH, Laszlo, S., 51, rte de Frontenex, CH- 1207 Genève (CH)**

(74) Mandataire: **Vuille, Roman, c/o KIRKER & Cie S.A. 14, rue du Mont- Blanc Case Postale 872, CH- 1211 Genève 1 (CH)**

LIBER, STOCKHOLM 1988

## Description

La présente invention se rapporte à un appareil de manutention automatique destiné à l'assemblage de pièces constitutives d'objets et à un procédé d'assemblage mettant en oeuvre un tel appareil.

De nos jours, l'emploi des robots industriels se diversifie toujours plus: de nouvelles branches de l'industrie introduisent progressivement de tels robots dans des domaines jusqu'alors inexploités; d'autre part, les tâches confiées à ces appareils de manutention robots évoluent elles-mêmes pour devenir plus complexes, plus délicates ou nécessiter plus de précision par exemple. Dans la manipulation d'objets en grandes séries, des opérations telles qu'assemblage, emboîtage, vissage ou soudure par exemple, nécessitent une très grande précision. Dans de telles opérations, la position desdits objets sur l'aire de travail proprement dite doit être, en effet, assurée avec des tolérances des plus minimes.

La demande de brevet FR-A-2 508 362 décrit un appareil pour l'assemblage automatique de pièces constitutives d'objets dont certaines d'entre elles au moins sont disposées sur un plateau agencé de manière à assurer le positionnement correct des pièces. Au moins une unité de travail se trouve fixée au-dessus du plan dans lequel la table susmentionnée se déplace.

Si le postionnement des pièces à assembler peut être réalisé dans l'aire de travail avec toute l'exactitude voulue à l'aide d'un dispositif de positionnement approprié, le traitement d'objets en grandes séries demande nombre de manipulations accessoires complexes qui ralentissent d'autant l'ensemble des opérations effectuées. Le problème à résoudre actuellement se situe au niveau du transport des pièces à assembler aur l'aire de travail et à leur mise en contact avec certains des éléments constitutifs du dispositif de positionnement, dans les positions et les orientations déterminées en fonction des opérations d'assemblage subséquentes. La mise en place desdites pièces s'effectue encore très souvent à la main; dans d'autres cas, notamment lors du transport et de la mise en place de aéries de pièces sur l'aire de travail, on a recours à l'emploi de palettes, le cas échéant préformées, assurant également le positionnement desdits pièces, telles des palettes en matériau thermoplastique par exemple. Les techniques actuelles, moulage ou thermoformage par exemple, ne permettent cependant pas d'obtenir des palettes dont la forme s'adapte avec suffisamment d'exactitude à celle des pièces à manipuler, plus particulièrement lorsque certaines des opérations citées plus haut doivent être effectuées. En fait, les appareils de manutention et d'assemblage connus à ce jour ne permettent pas d'assurer le transport collectif et le positionnement collectif de séries de pièces à assembler dans des conditions rationnelles. Ces lacunes sont avantageusement comblées par le robot selon la présente invention et sa mise en oeuvre.

La présente invention a plus précisément pour objet un appareil de manutention automatique destiné à l'assemblage de pièces constitutives d'objets, comprenant au moins une tête de travail pourvue d'un outil effectuant au-dessus d'une aire de travail des mouvements commandés par un programme selon au moins trois degrés de liberté et comprenant, dans ladite aire de travail, un magasin fixe pourvu de moyens de maintien exact des pièces en des emplacements prédéterminés. L'appareil se caractérisé en ce q'il comporte un moins un réceptacle préformé amovible assurant le transport collectif des pièces à assembler vers ou hors de l'aire de travail, conformé pour maintenir avec un certain jeu lesdites pièces dans des positions et des orientations correspondant à celes déterminées par ledit magasin fixe et tel que, lorsque le réceptacle amovible chargé de pièces est approché du magasin fixe, les pièces peuvent être maintenues dans les emplacement prédéterminés par les moyens dudit magasin fixe durant le travail d'assemblage jusqu'à ce que le réceptacle soit écarté en emportant toutes pièces encore maintenues par le magasin.

Un deuxième objet de l'invention est représenté par le procédé de la revendication 6.

Les dessins annexés illustrent à titre purement indicatif certaines des exécutions de l'appareil de manutention défini ci-dessus.

Figure 1 représente vu de profil un selon la présente invention.

Figure 2 représente vu en plan l'appareil de mainutention illustré par Fig. 1.

Figures 3 et 4, respectivement 5 et 6, illustrent soit en plan, soit en profil, le détail de deux exécutions particulières de l'appareil de manutention selon l'invention.

Figures 7, respectivement 8 et 9 illustent, vu en plan et en profil, le détail d'une autre exécution du de l'appareil de manutention selon l'invention.

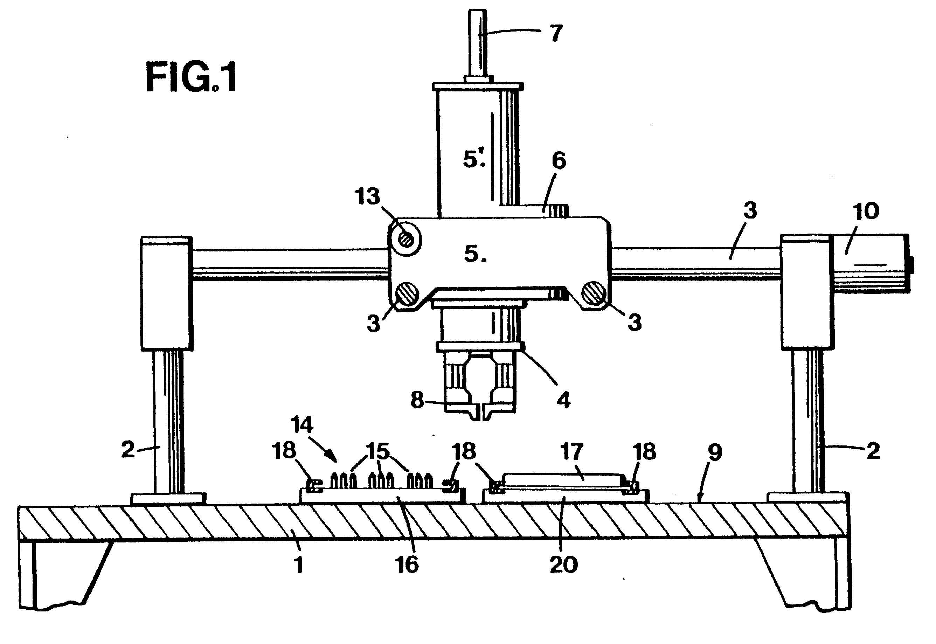

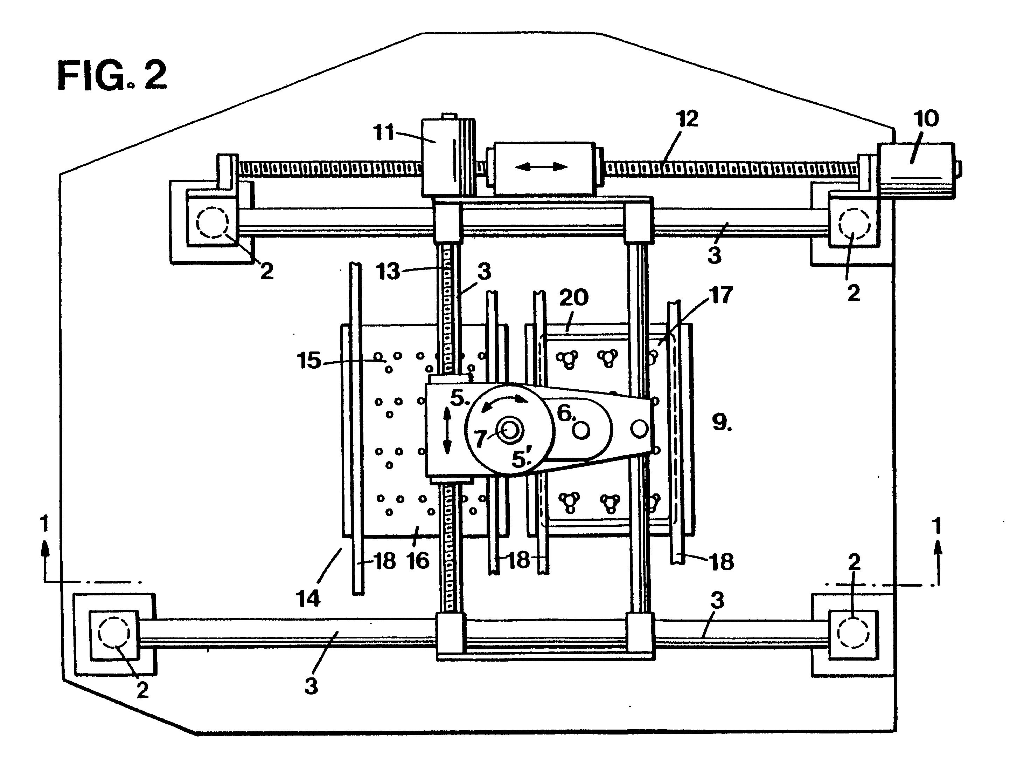

Tel que représenté par Fig. 1 et 2, l'appareil de manutention comporte un bâti 1, supportant des montants 2 eux-mêmes porteurs de moyens 3 assurant le guidage d'au moins une tête de travail 4. Ladite tête de travail comporte un corps principal 5 coopérant avec les moyens de guidage 3, surmonté d'un boîtier 5' et d'un moteur 6 ou de tout autre dispositif pouvant assurer la rotation de ladite tête de travail autour de son axe 7. C'est par exemple par l'intermédiaire de cet axe 7 que la tête 4 peut être reliée aux divers moyens de commande. Dans l'exécution représentée, la tête 4 est pourvue d'une pince de préhension 6.

Les divers mouvements de la tête de travail 4, qui peut se déplacer au-dessus de l'aire de travail 9 avec trois degrés de liberté au moins, sont engendrés et contrôlés à l'aide des instruments usuels tels des servomoteurs 10, 11 entraînant des vis sans fin 12, 13 par exemple. La tête de travail 4 et ses éléments annexes prennent appui sur les éléments 12, respectivement 13 et, sur les moyens de guidage appropriés 3 de façon usuelle; le glissement sur les moyens 3 peut être assuré par exemple à l'aide de roulements conventionnels. Les mouvements de la tête de travail 4, de même que ceux de l'outil 8, sont commandés par un programme. L'ensemble du système est en outre contrôlé par un ou plusieurs microprocesseurs, voire un ordinateur.

L'appareil de manutention automatique comporte sur au moins une partie de l'aire de travail 9 un dispositif de positionnement exact 14 des objets à manipuler. Ce dispositif 14 comprend des éléments rigides espacés 15, solidaires d'un support amovible 16. Ledit support 16 est en effet de préférence amovible afin de pouvoir être substitué en temps voulu à un autre support 16 sur lequel l'arrangement des éléments rigides 15 est différent: on peut de ce fait adapter en tout temps le dispositif 14 à la forme particulière des objets à manipuler. Selon les besoins en outre, la fixation du support 16 du bâti 1 peut être assurée par tout moyen adéquat tel que vis, crochets ou aimants par exemple.

Les éléments rigides 15 sont disposés perpendiculairement à la surface de l'aire de travail 9, s'élevant au-dessus du support 16. Lesdits éléments 15 peuvent consister par exemple en des goupilles de forme conique, tronconique, cylindrique ou prismatique par exemple, convenablement solidarisées dudit support; de telles goupilles peuvent être vissées ou soudées au support 16 ou chassées du travers de ce dernier par exemple. En outre, le support amovible 16 sera conçu de façon à pouvoir supporter une contrainte mécanique.

L'arrangement des éléments 15 à la surface du support 16 sera fonction de la nature des objets à manipuler, notamment de leur forme, ainsi que de l'orientation à leur donner.

L'appareil de manutention automatique comprend au moins un réceptacle préformé amovible 17, assurant le transport collectif des pièces à assembler vers ou hors de l'aire de travail 9, et conformé pour maintenir avec un certain jeu lesdites pièces dans des positions et des orientations relatives semblables à celles déterminées par le dispositif 14. Ledit réceptacle 17 est en outre agencé pour coopérer avec le dispositif 14 mentionné ci-dessus.

Le réceptacle 17 peut se présenter par exemple sous la forme d'un plateau en matériau thermoformable, présentant des perforations 21 conformées pour être traversées par les éléments 15 lorsque ledit réceptacle prend appui sur le support 16, ainsi que des godets 22 récepteurs des pièces à manipuler et définissant des espaces suffisants pour accepter un léger déplacement desdites pièces sous l'effet du dispositif de positionnement 14.

En fonction des tâches assignées à l'appareil d'assemblage, le réceptacle 17 sera conformé pour assurer le transport d'une ou plusieurs séries de pièces identiques, ou d'une ou plusieurs séries de pièces différentes les unes des autres.

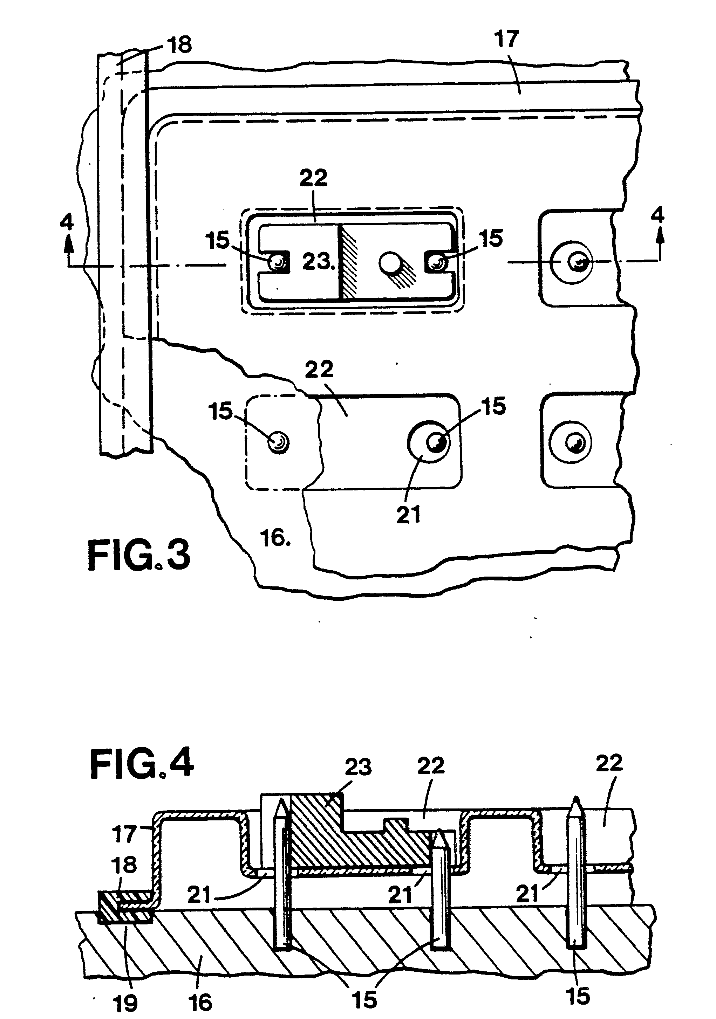

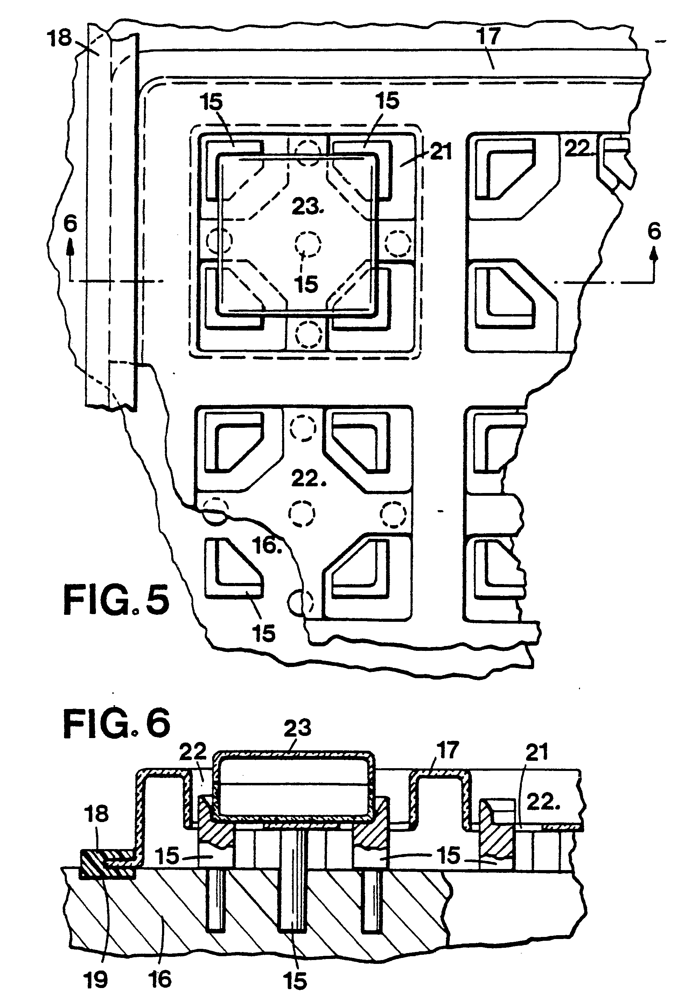

Le déroulement des opérations relatives au transport et du positionnement exact des pièces à assembler peut être décrit comme suit (Fig. 3 à 6): préalablement rempli, hors de l'aire de travail 9, avec les pièces sélectionnées 23, le réceptacle préformé 17 est amené sur l'aire de travail 9, par exemple à l'aide de courroies 18 coulissant dans des guides appropriés ou des gorges 19 aménagées dans l'élément 16 du dispositif de positionnement 14, respectivement une plaque de dépose 20 par exemple. Le maintien du réceptacle 17 peut être par exemple réalisé par pincement ou tout autre moyen adéquat et les déplacements dudit réceptacle contrôlés par le dispositif de commande de l'appareil.

Une fois amené au-dessus du dispositif 14, le réceptacle 17 préformé et perforé est alors abaissé jusqu'à la hauteur voulue, les éléments rigides 15, des goupilles cylindriques à tête conique par exemple, passant alors du travers des perforations 21 aménagées dans les godets 22. Les pièces 23 entrent alors en contact étroit avec lesdits éléments 15 et coulissent le long de ceux-ci pour prendre finalement la position définie avec exactitude par l'ensemble des éléments 15. Dans une autre exécution, on peut concevoir un dispositif 14 subissant une translation verticale, le réceptacle 17 demeurant posé sur la surface 9 du bâti 1.

Une fois les opérations d'assemblage terminées, le réceptacle 17 peut être retiré de l'aire de travail, acheminant les objets terminés vers une zone de dépose par exemple.

Selon les cas, les éléments rigides 15 peuvent servir à assurer aussi bien le positionnement latéral des objets à manipuler que leur positionnement en hauteur. Les perforations 21 aménagées dans les réceptacles 22 présentent de préférence une section légèrement supérieure à celle des éléments 15 du dispositif 14 auxquelles elles correspondent.

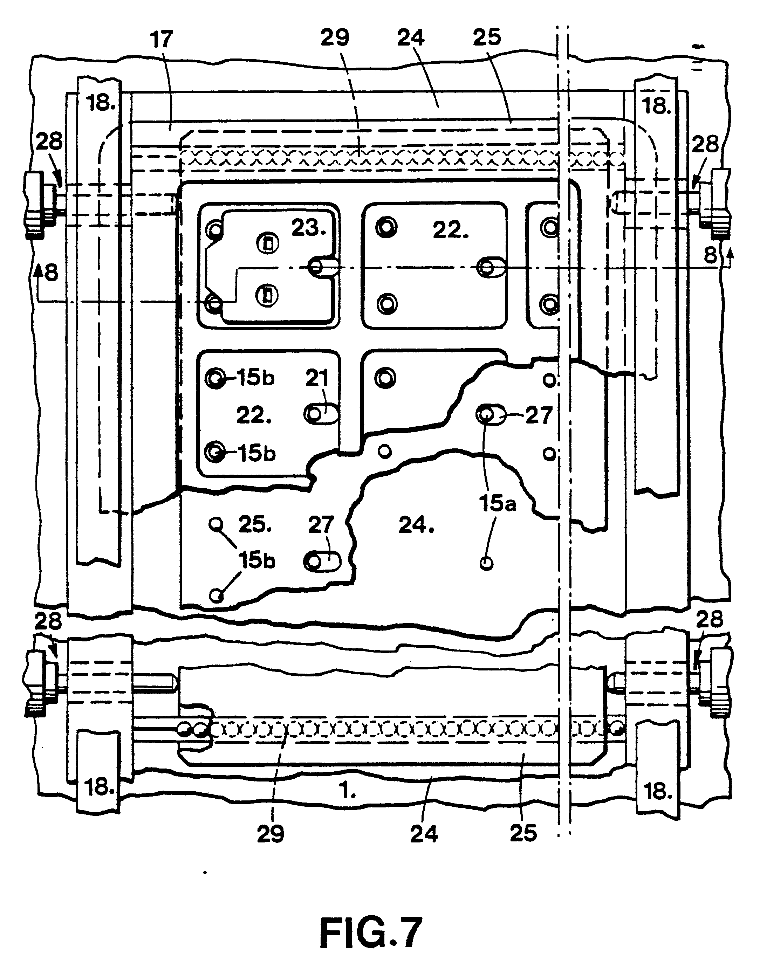

Dans une autre exécution de l'appareil selon invention (Fig. 7 à 9), le dispositif de positionnement 14 comporte un support amovible 16 se composant de deux plaques superposées 24, 25 porteuses d'éléments rigides espacés 15a, respectivement 5b, lesdites plaques étant agencées de façon à pouvoir se déplacer l'une par rapport à l'autre selon un axe du moins de leur surface de contact commune 26. Les déplacements relatifs des plaques 24 et 25 peuvent être réalisés à l'aide de tout moyen adéquat, tels par exemple des moyens 28 comprenant un ou plusieurs vérins actionnant la plaque mobile 25 par deux de ses côtés. Des moyens de guidage 29 assureront en outre le déplacement de ladite plaque mobile 25 selon l'axe désiré: de tels moyens peuvent par exemple comprendre une ou plusieurs goupilles engagées dans des rainures correspondantes, ou une série de billes coopérant avec des gorges aménagées dans la face supérieure, respectivement inférieure, de la plaque 24, respectivement 25 (Fig. 7). La commande de tels mouvements peut être programmée en fonction du déroulement des opérations d'assemblage.

Dans cette exécution particulière, la plaque supérieure 25 présente des perforations 27 traversées par les éléments 15a solidaires de la plaque 24. La section desdites perforations 27 ainsi que celle des perforations 21 du réceptacle 17 sont alors calculées de façon à pouvoir absorber la course maximum de la plaque 25 nécessaire au serrage des pièces 23 entre les éléments rigides 15a, 15b.

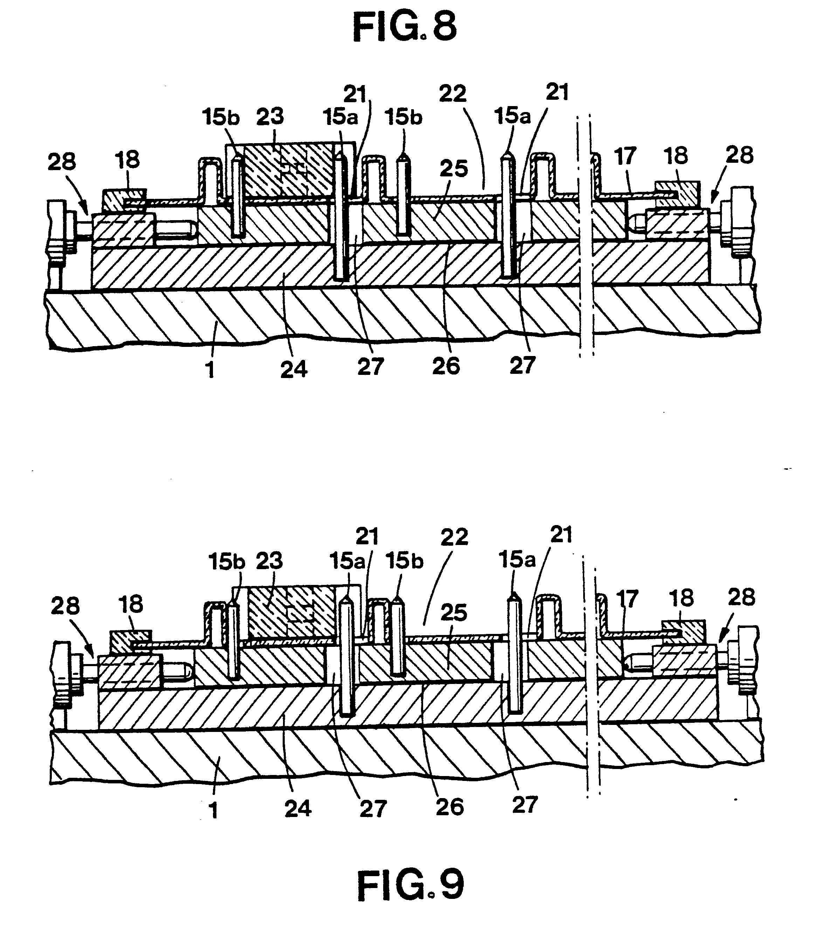

Figure 8, qui est une coupe selon 8, 8 de Figure 7, illustre la situation dans laquelle lesdites pièces 239 sont serrées entre les éléments 15d, 15b. Dans Fig. 9, les éléments sont écartés les une des autres sous l'effet des moyens 28 et les pièces 23 dégagées desdits éléments 15a, 15b.

Le déroulement des opérations de transport, avant et après assemblage des pièces 23, est identique à celui décrit précédemment, l'exactitude du positionnement et des orientations relatives desdites pièces 23 étant assuré par un effet de serrage des éléments 156, 15b.

Il a été constaté que l'application du procédé d'assemblage mettant en oeuvre l'appareil de manutention automatique était particulièrement bien adapté à l'assemblage en séries de pièces constitutives d'objets, notamment de grandes séries. Il est évident que ledit procédé peut également s'appliquer à l'assemblage, pièce par pièce, d'un seul objet à la fois.

**Revendications**

1. Appareil de manutention automatique destiné à l'assemblage de pièces constitutives d'objets, comprenant au moins une tête de travail (4) pourvue d'un outil (8) effectuant au-dessus d'une aire de travail (9) des mouvements commandés par un programme selon au moins trois degrés de liberté et comprenant, dans ladite aire de travail (9), un magasin fixe (14) pourvu de moyens de maintien exact des pièces en des emplacements prédéterminés, caractérisé en ce qu'il comporte au moins un réceptacle préformé amovible (17) assurant le transport collectif des pièces à assembler vers ou hors de l'aire de travail (9), conformé pour maintenir avec un certain jeu lesdites pièces dans des positions et des orientations correspondant à celles déterminées par ledit magasin fixe et tel que, lorsque le réceptacle amovible (17) chargé de pièces est approché du magasin fixe (14), les pièces peuvent être maintenues dans les emplacements prédéterminés par les moyens dudit magasin fixe durant le travail d'assemblage jusqu'à ce que le réceptacle (17) soit écarté en emportant toutes les pièces encore maintenues par le magasin (14).

2. Appareil selon la revendication 1, caractérisé en ce que le magasin fixe (14) comprend des éléments rigides espacés (15) solidaires d'un support amovible (16), conçu afin d'exercer une contrainte mécanique, et disposés perpendiculairement à la surface dudit support (16), et que le réceptacle (17) présente des perforations (21) conformées pour être traversées par les éléments (15) lorsque le réceptacle (17) prend appui sur le support (16).

3. Appareil selon l'une des revendications 1 et 2, caractérisé en ce que le magasin fixe (14) comporte un support amovible (16) se composant de deux plaques superposées (24, 25) porteuses d'éléments rigides espacés (15a), respectivement (15b), lesdites plaques étant agencées de façon à pouvoir se déplacer l'une par rapport à l'autre selon un axe au moins de leur surface de contact commune (26).

4. Appareil selon la revendication 3, caractérisé en ce que la plaque supérieure (25) présente des perforations (27) traversées par les éléments (15a) solidaires de la plaque (24), et que la section desdites perforations (27) ainsi que celle des perforations (21) du réceptacle (17) sont calculées de façon à pouvoir absorber la course maximum de la plaque (25) nécessaire au serrage des pièces entre les éléments rigides (15a, 15b).

5. Appareil selon l'une des revendications 1 à 4, caractérisé en ce que le réceptacle (17) présente des godets (22) récepteurs des pièces à manipuler et définissant des espaces suffisants pour accepter un déplacement des pièces à manipuler sous l'effet du magasin fixe (14).

6. Procédé d'assemblage de pièces constitutives d'objets selon lequel lesdites pièces sont maintenues dans une aire de travail (9) dans des positions et des orientations exactes à l'aide d'un magasin fixe (14) pourvu de moyens de maintien exact des pièces en des emplacements prédéterminés en vue de leur manipulation par au moins un outil (8) monté sur une tête de travail (4) effectuant des mouvements commandés par un programme, caractérisé en ce que l'on dispose lesdites pièces, préalablement à leur assemblage et hors de l'aire de travail (9), dans un réceptacle amovible (17) conformé de façon telle que les pièces sont maintenues avec un certain jeu dans des positions et des orientations correspondant à celles déterminées par le magasin fixe (14) et tel que lorsque ledit réceptacle chargé de pièces est approché du magasin fixe (14), les pièces peuvent être maintenues dans les emplacements prédéterminés par les moyens dudit magasin durant le travail d'assemblage, on amène le réceptacle (17) dans l'aire de travail (9), on dispose ensuite ledit réceptacle dans l'aire de travail de façon à mettre chacune des pièces contenues dans le réceptacle en contact direct avec une partie au moins des moyens de maintien exact du magasin fixe (14) et, le cas échéant, on retire le réceptacle (17), y compris toutes pièces encore maintenues par le magasin (14), de l'aire de travail une fois les opérations d'assemblage terminées.

7. Procédé selon la revendication 6, caractérisé en ce que le magasin fixe (14) comprend des éléments rigides espacés (15) solidaires d'un support amovible (16), conçu afin d'exercer une contrainte mécanique, et disposés perpendiculairement à la surface dudit support (16), et que le réceptacle (17) présente des perforations (21) conformées pour être traversées par les éléments (15) lorsque le réceptacle (17) prend appui sur le support (16).

8. Procédé selon l'une des revendications 6 et 7, caractérisé en ce que le réceptacle (17) est conformé pour transporter une ou plusieurs séries de pièces identiques.

9. Procédé selon l'une des revendications 6 et 7, caractérisé en ce que le réceptacle (17) est conformé pour transporter une ou plusieurs séries de pièces distinctes les unes des autres.

10. Procédé selon l'une des revendications 6 à 9, caractérisé en ce que les pièces constitutives d'objets destinées à être assemblées sont des pièces d'un assemblage en série.


**Patentansprüche**

1. Automatische Handhabungsvorrichtung zum Zusammenbau von Bauteilen eines Erzeugnisses bestehend aus mindestens einem Arbeitskopf (4) mit einem Werkzeug (8), der oberhalb einer Arbeitsfläche (9) programmgesteuerte Bewegungen mit mindestens drei Freiheitsgraden ausführt, und wobei auf besagter Arbeitsfläche (9) ein Festmagazin (14) angeordnet ist mit Mitteln zur genauen Haltung der Bauteile an vorgegebenen Positionen, dadurch gekennzeichnet, dass sie besteht aus mindestens einer festen, vorgeformten Aufnahme (17) zum gemeinsamen Transport der zusammenzubauenden Bauteile zur oder von der Arbeitsfläche (9) und ausgebildet, um besagte Bauteile mit einem bestimmten Spiel in Stellungen und Orientierungen halten, die denen vom besagten Festmagazin bestimmten entsprechen und wobei beim Annähern der festen, mit Bauteilen geladenen Aufnahme (17) an das Festmagazin (14) die Bauteile an ihren vorgegebenen Positionen mit Mitteln besagten Festmagazins während der Zusammenbauphase so lange gehalten werden können bis die Aufnahme (17) weggerückt worden ist und wobei alle noch im Festmagazin (14) vorhandenen Bauteile entfernt werden.

2. Vorrichtung nach Patentanspruch 1, dadurch gekennzeichnet, daß

das Festmagazin (14) aus starren, distanzierten Elementen (15) besteht, die mit einer festen, eine mechanische Spannung ausübenden Auflage (16) fest verbunden sind, und die senkrecht zur Oberfläche besagter Auflage (16) angeordnet sind, und dass die Aufnahme (17) Öffnungen (21) aufweist, die so ausgebildet sind, dass die Elemente (15) durch sie hindurchgeführt werden können, wenn die Aufnahme (17) auf der Auflage (18) aufliegt.

3. Vorrichtung nach einem der Patentansprüche 1 und 2, dadurch gekennzeichnet, daß das Festmagazin (14) eine feste Auflage (16) enthält, die aus zwei übereinander angeordneten Platten (24, 25) besteht, welche die starren, distanzierten Elemente (15a) beziehungsweise (15b) tragen, wobei besagte Platten so angeordnet sind, dass sie zueinander im mindestens eine Achse ihrer gemeinsamen Berührungsfläche (26) verschoben werden können.

4. Vorrichtung nach Patentanspruch 3, dadurch gekennzeichnet, daß die obere Platte (25) Öffnungen (27) aufweist, durch welche die in der Platte (24) angeordneten Elemente (15a) ragen, und dass der Querschnitt der besagten Öffnungen (27) sowie der der Öffnungen (21) der Aufnahme (17) so dimensioniert sind, dass sie sich für den maximalen Hub der Platte (25) eignen, der zum Spannen der Bauteile zwischen den starren Elementen (15a, 15b) erforderlich ist.

5. Vorrichtung nach einem der Patentansprüche 1 bis 4, dadurch gekennzeichnet, daß die Aufnahme (17) Becher (22) zur Aufnahme der zusammenzubauenden Bauteile aufweist, auf denen genügend Platz für eine Verschieschiebung der zusammenzubauenden Bauteile unter Wirkung des Festmagazins (14) vorhanden ist.

6. Verfahren zum Zusammenbau von Bauteilen eines Erzeugnisses gemäss dem besagte Bauteile auf einer Arbeitsfläche (9) in genauen Stellungen und Orientierungen mit Hilfe eines Festmagazins (14) gehalten werden, das mit Mitteln zur genauen Haltung der Bauteile an vorgegebenen Positionen versehen ist zwecks ihrer Handhabung mit mindestens einem Werkzeug (8), das auf einem Arbeitskopf (4) ist, der programmgesteuerte Bewegungen ausführt, dadurch gekennzeichnet, daß besagte Bauteile vor ihrem Zusammenbau sich ausserhalb der Arbeitsfläche (9) in einer festen Aufnahme (17) befinden, die so ausgebildet ist, dass besagte Bauteile mit einem bestimmten Spiel in Stellungen und Orientierungen gehalten werden, die denen vom besagten Festmagazin bestimmten entsprechen und wobei beim Annähern der festen, mit Bauteilen geladenen Aufnahme (17) an das Festmagazin (14) die Bauteile an ihren vorgegebenen Positionen mit Mitteln besagten Festmagazins während der Zusammenbauphase gehalten werden, die Aufnahme (17) auf die Arbeitsfläche (9) gebracht wird, dann besagte Aufnahme auf der Arbeitsfläche in der Weise zur Verfügung gestellt wird, um jedes der in der Aufnahme enthaltenen Bauteiles in direkten Kontakt mit einem Teil mindestens der genauen Haltemittel des Festmagazins (14) zu bringen, und, gegebenenfalls, die Aufnahme (17) unter Einschluss aller noch im Festmagazin (14) vorhandenen Bauteile von der Arbeitsfläche (9) zurückgezogen wird, sobald die Zusammenbauoperationen abgeschlossen sind.

7. Verfahren nach Patentanspruch 6, dadurch gekennzeichnet, daß

das Festmagazin (14) aus starren, distanzierten Elementen (15) besteht, die mit einer festen, eine mechanische Spannung ausübenden Auflage (18) fest verbunden sind, und die senkrecht zur Oberfläche besagter Auflage (18) angeordnet sind, und daß die Aufnahme (17) Öffnungen (21) aufweist, die so ausgebildet sind, daß die Elemente (15) durch sie hindurchgeführt werden können, wenn die Aufnahme (17) auf der Auflage (16) aufliegt.

8. Verfahren nach einem der Patentansprüche 6 und 7, dadurch gekennzeichnet, daß die Aufnahme (17) so ausgebildet ist, daß sie ein oder mehrere Serien identischer Bauteile transportieren kann.

9. Verfahren nach einem der Patentansprüche 6 und 7, dadurch gekennzeichnet, daß die Aufnahme (17) so ausgebildet ist, daß sie ein oder mehrere Serien zueinander unterschiedlicher Bauteile transportieren kann.

10. Verfahren nach einem der Patentansprüche 6 bis 9, dadurch gekennzeichnet, daß die Bauteile, aus denen sich das Erzeugnis zusammensetzt und die zusammengebaut werden sollen, Bauteile für eine Seriefertigung sind.

## Claims

1. An automatic handling apparatus for assembling constituent components of articles, comprising at least one working head (4) provided with a tool (8), which performs, above a working area (9), movements controlled by a program according to at least three degrees of freedom, and comprising, in the said working area (9), a fixed magazine (14) provided with means for holding the components precisely in predetermined locations, characterized in that it includes at least one detachable preformed receptacle (17) for collectively conveying the components to be assembled into or out of the working area (9), the said receptacle being shaped so as to hold the said components, with a certain amount of play, in positions and orientations corresponding to those determined by the said fixed magazine, and being such that, when the detachable receptacle (17) loaded with components is moved towards the fixed magazine (14), the components can be held in the predetermined locations by the means of the said fixed magazine during the assembly work until the receptacle (17) is moved away, carrying with it all the components still held by the magazine (14).

2. The apparatus according to Claim 1, characterized in that the fixed magazine (14) comprises spaced-out rigid elements (15) which are firmly fixed to a detachable support (16) designed so as to exert a mechanical stress, and which are placed perpendicularly to the surface of the said support (16), and in that the receptacle (17) has perforations (21) shaped so that the elements (15) can pass through them when the receptacle (17) rests on the support (16).

3. The apparatus according to one of Claims 1 and 2, characterized in that the fixed magazine (14) includes a detachable support (16) composed of two superposed plates (24, 25) carrying spaced-out rigid elements (15a) and (15b) respectively, the said plates being arranged so that they can move relative to one another along at least one axis of their common contact surface (26).

4. The apparatus according to Claim 3, characterized in that the upper plate (25) has perforations (27) through which the elements (15a) firmly fixed to the plate (24) pass, and in that the cross-section of the said perforations (27) and that of the perforations (21) in the receptacle (17) are calculated so as to be able to accommodate the maximum travel of the plate (25) which is necessary for gripping the components between the rigid elements (15a, 15b).

5. The apparatus according to one of Claims 1 to 4, characterized in that the receptacle (17) has cups (22) which receive the components to be manipulated and define sufficient spaces for accepting a displacement of the components to be manipulated, under the action of the fixed magazine (14).

6. A process for assembling constituent components of articles, wherein the said components are held in a working area (9) and in precise positions and orientations by means of a fixed magazine (14) provided with means for holding the components precisely in predetermined locations so that they can be manipulated by at least one tool (8) mounted on a working head (4) which performs movements controlled by a program, characterized in that, prior to being assembled, and outside the working area (9), the said components are placed in a detachable receptacle (17) which is shaped so that the components are held, with a certain amount of play, in positions and orientations corresponding to those determined by the fixed magazine (14), and which is such that, when the said receptacle loaded with components is moved towards the fixed magazine (14), the components can be held in the predetermined locations by the means of the said magazine during the assembly work, the receptacle (17) is brought into the working area (9), the said receptacle is then placed in the working area so as to bring each of the components contained in the receptacle into direct contact with at least part of the precision holding means of the fixed magazine (14), and, if appropriate, the receptacle (17), together with any components still held by the magazine (14), are withdrawn from the working area once the assembly operations have been completed.

7. The process according to Claim 6, characterized in that the fixed magazine (14) comprises spaced-out rigid elements (15) which are firmly fixed to a detachable support (16) designed so as to exert a mechanical stress, and which are placed perpendicularly to the surface of the said support (16), and in that the receptacle (17) has perforations (21) shaped so that the elements (15) can pass through them when the receptacle (17) rests on the support (16).

8. The process according to one of Claims 6 and 7, characterized in that the receptacle (17) is shaped for conveying one or more series of identical components.

9. The process according to one of Claims 6 and 7, characterized in that the receptacle (17) is shaped for conveying one or more series of components which differ from one another.

10. The process according to one of Claims 6 to 9, characterized in that the constituent components of articles which are to be assembled are components of a mass-produced assembly.

FIG.1

0 154 633

FIG. 2

FIG.3

FIG.4

**FIG. 5**

**FIG. 6**

**FIG.7**

# FIG. 8

# FIG. 9